(19) Europäisches Patentamt / European Patent Office / Office européen des brevets

(11) **EP 4 701 060 A1**

(12) **EUROPEAN PATENT APPLICATION**
published in accordance with Art. 153(4) EPC

(43) Date of publication:
**25.02.2026 Bulletin 2026/09**

(21) Application number: **24792166.1**

(22) Date of filing: **20.04.2024**

(51) International Patent Classification (IPC):
*H02M 3/158* (2006.01)   *H02M 1/088* (2006.01)
*H02M 1/38* (2007.01)   *H03K 17/687* (2006.01)

(52) Cooperative Patent Classification (CPC):
Y02B 70/10

(86) International application number:
**PCT/CN2024/088994**

(87) International publication number:
**WO 2024/217583 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.04.2023 CN 202310431869**

(71) Applicant: **Vanchip (Tianjin) Technology Co. Ltd**
**Tianjin 300457 (CN)**

(72) Inventors:
• **CHEN, Cheng**
  **Tianjin 300457 (CN)**

• **LI, Songke**
  **Tianjin 300457 (CN)**
• **LIANG, Shengyu**
  **Tianjin 300457 (CN)**
• **LI, Chunling**
  **Tianjin 300457 (CN)**
• **WANG, Yongshou**
  **Tianjin 300457 (CN)**
• **GAO, Chenyang**
  **Tianjin 300457 (CN)**

(74) Representative: **Wang, Bo**
**Panovision IP**
**Ebersberger Straße 3**
**85570 Markt Schwaben (DE)**

(54) **DC-DC CONVERTER, CHIP, AND ELECTRONIC DEVICE**

(57) Disclosed in the present invention are a DC-DC converter, a chip, and a corresponding electronic device. The DC-DC converter comprises a power-stage circuit unit and a control loop unit, wherein a control signal output end of a baseband is connected to an input end of the control loop unit, a control signal output end of the control loop unit is connected to a corresponding input end of the power-stage circuit unit, and a sampling voltage output end of the power-stage circuit unit is connected to the corresponding input end of the control loop unit, so as to form a closed control loop. With regard to the DC-DC converter, in a control loop unit, by means of the technical solution of performing weighted superposition on a power source voltage, a sampling voltage, a controllable reference voltage and a fixed current to form a slope compensation voltage, and the technical solution of FPWM/FCCM logic control, fast tracking of an output voltage of the DC-DC converter in respect of a transmission power is realized, such that the efficiency is ensured, and a transient conversion response speed of the output voltage is also greatly increased.

FIG. 2

Description

BACKGROUND

**Technical Field**

The present invention relates to a DC-DC converter, also relates to an integrated circuit chip including the DC-DC converter and a corresponding electronic device, and belongs to the field of analog integrated circuit technologies.

**Related Art**

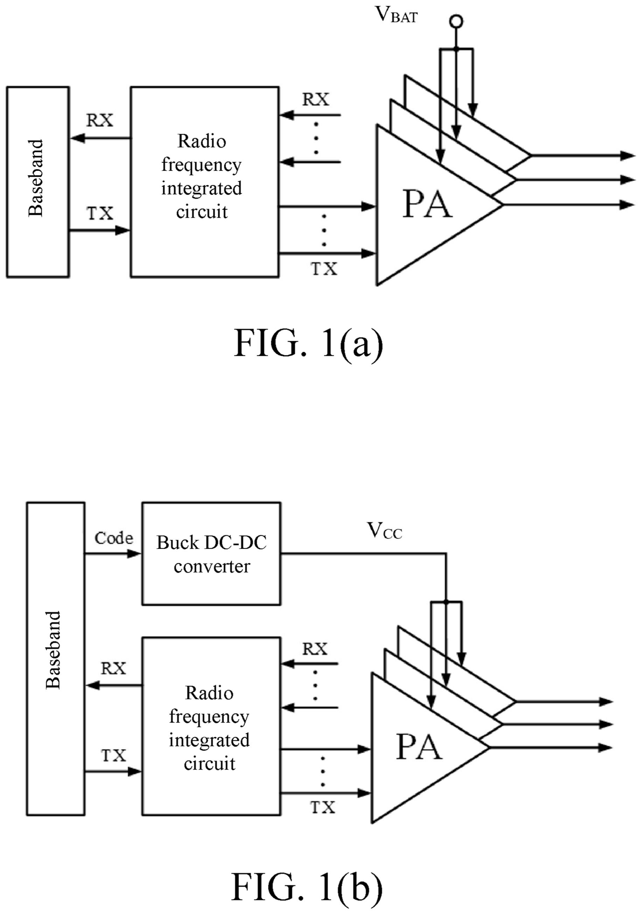

It is well known that efficiency of a radio frequency front-end module is closely related to an architecture of an entire radio frequency front-end module. In the related art, there are two different radio frequency front-end module architectures based on different power supply modes. As shown in FIG. 1(a), a typical radio frequency front-end module is a constant power supply voltage architecture, where a power supply voltage of a power amplifier is a fixed voltage $V_{BAT}$. As shown in FIG. 1(b), another typical radio frequency front-end module is an automatic power tracking (APT) power supply voltage architecture. A power supply voltage of a power amplifier uses an APT mode, and is provided by an output voltage $V_{CC}$ of a buck DC-DC converter. In comparison with the foregoing two radio frequency front-end module architectures, working efficiency of the radio frequency front-end module architecture using the APT mode is higher.

In the radio frequency front-end module architecture using the APT mode, when the DC-DC converter uses a conventional voltage-mode structure, the output voltage $V_{CC}$ of the DC-DC converter is within a jump range (Vmin to Vmax). Because a timing constraint of a system needs to satisfy extremely short voltage transition time (Transition time), a bandwidth of an error amplifier needs to be ensured to be sufficiently large to satisfy a loop bandwidth and a response speed of the DC-DC converter. In this case, the error amplifier consumes more quiescent currents, and consequently, efficiency of the DC-DC converter is reduced. In addition, an increase in the loop bandwidth of the DC-DC converter further affects stability of a loop. The loop is more sensitive to noise introduced by an off-chip output voltage $V_{CC}$, and consequently, a circuit may oscillate. Therefore, how to avoid the foregoing problem and provide a power supply capable of achieving a rapid response in an APT mode, to satisfy a high response speed requirement of a 5G communication system remains a critical research topic in this field.

In Chinese Patent Application No. CN 103345289B, a slope compensation adaptive control circuit is disclosed, including: a voltage sampling circuit, configured to obtain a feedback voltage representing an output voltage; a transconductance amplification circuit, configured to generate a voltage compensation signal based on the feedback voltage and a preset reference voltage; a current compensation circuit, configured to generate a slope compensation signal based on a compensation current varying with a switching frequency and a sampling current representing an inductor current value of a power-stage circuit; a comparison circuit, configured to generate a PWM control signal based on the voltage compensation signal and the slope compensation signal; and a driving circuit, configured to drive the power-stage circuit based on an external clock signal and the PWM control signal. The circuit satisfies requirements of good stability and a rapid dynamic response of a switching power supply at different switching frequencies.

**SUMMARY**

A primary technical problem to be resolved by the present invention is to provide a DC-DC converter.
Another technical problem to be resolved by the present invention is to provide an integrated circuit chip including the DC-DC converter and a corresponding electronic device.
In order to achieve the foregoing objective, the present invention uses the following technical solutions.
According to a first aspect of embodiments of the present invention, a DC-DC converter is provided, including a power-stage circuit unit, and further including a control loop unit, wherein

a first control signal output end and a second control signal output end of the control loop unit are separately connected to the power-stage circuit unit, and a first sampled voltage output end and a second sampled voltage output end of the power-stage circuit unit are separately connected to the control loop unit, to form a closed control loop;
the control loop unit generates a first control signal and a second control signal based on a baseband control signal of a radio frequency front-end module, a first sampled voltage, and a second sampled voltage, and provides the first control signal and the second control signal to the power-stage circuit unit; and
the power-stage circuit unit adjusts an output voltage based on the first control signal and the second control signal, to implement fast tracking of the output voltage of the DC-DC converter in respect of transmission power.

Preferably, the power-stage circuit unit includes a power supply module, a dead-time and driver module, an output voltage sampling network module, a PMOS power switch transistor, an NMOS power switch transistor, a load resistor, a power inductor, and a ceramic capacitor, wherein

a first input end and a second input end of the dead-time and driver module are separately connected to the control signal output ends of the control loop unit, a first output end of the dead-time and driver module is connected to a gate of the PMOS power switch transistor, and a second output end of the dead-time and driver module is connected to a gate of the NMOS power switch transistor; a source of the PMOS power switch transistor is connected to a positive electrode of the power supply module, and a negative electrode of the power supply module is connected to a ground potential end; a drain of the PMOS power switch transistor is connected to a drain of the NMOS power switch transistor and the power inductor, and a source of the NMOS power switch transistor is connected to the ground potential end; another end of the power inductor is connected to the load resistor, the ceramic capacitor, and a voltage output end, and another end of the load resistor and another end of the ceramic capacitor are both connected to the ground potential end; and an input end of the output voltage sampling network module is connected to the voltage output end, and a first sampled voltage output end and a second sampled voltage output end of the output voltage sampling network module are respectively connected to corresponding input ends of the control loop unit; and

the dead-time and driver module is configured to generate a corresponding fourth control signal and fifth control signal based on the input first control signal and second control signal, to control a turned-on state and a turned-off state of the PMOS power switch transistor and the NMOS power switch transistor.

Preferably, the control loop unit includes a logic control unit and a loop core module, wherein

a control signal output end of a baseband, and the first sampled voltage output end and the second sampled voltage output end of the power-stage circuit unit are respectively connected to corresponding input ends of the loop core module;

a controllable reference voltage output end, a third control signal output end, and a frequency signal output end of the loop core module are respectively connected to corresponding input ends of the logic control unit; and

a control signal output end of the logic control unit is connected to an input end of the power-stage circuit unit.

Preferably, the loop core module includes a register control module, a reference voltage and reference current module, a Vramp generation module, an error amplifier module, a comparator module, and a Clk generation module, wherein

a control signal output end of a baseband is connected to an input end of the register control module, a voltage output end of the power supply module $V_{BAT}$ is connected to a first input end of the Vramp generation module, a first sampled voltage output end of the output voltage sampling network module is connected to a second input end of the Vramp generation module, and a second sampled voltage output end of the voltage sampling network module is connected to a first input end of the error amplifier module;

an output end of the register control module is connected to an input end of the reference voltage and reference current module, and a first output end of the reference voltage and reference current module is separately connected to a third input end of the Vramp generation module and a second input end of the error amplifier module, and is connected to a first input end of the logic control unit; a second output end of the reference voltage and reference current module is connected to an input end of the Clk generation module, and a third output end of the reference voltage and reference current module is connected to a fourth input end of the Vramp generation module; and an output end of the Vramp generation module is connected to an in-phase input end of the comparator module, and an output end of the error amplifier module is connected to an out-phase input end of the comparator module; and

an output end of the comparator module is connected to a second input end of the logic control unit, and an output end of the Clk generation module is connected to a third input end of the logic control unit.

the register control module is configured to receive a control signal from the baseband, convert the control signal into a sixth control signal, and output the sixth control signal to the reference voltage and reference current module;

the reference voltage and reference current module is configured to generate a corresponding controllable reference voltage, fixed reference voltage, and fixed current based on the input sixth control signal, where the controllable reference voltage is separately output to the Vramp generation module, the error amplifier module, and the logic control unit, the fixed reference voltage is output to the Clk generation module, and the fixed current $I_{Charge}$ is output to the Vramp generation module;

the Vramp generation module is configured to generate a slope compensation voltage based on the input controllable reference voltage and fixed current, the first sampled voltage, and a power supply voltage, and output the slope compensation voltage to the comparator module;

the error amplifier module is configured to output an error adjustment voltage to the comparator module through difference amplification based on the input controllable reference voltage and the second sampled voltage;

the comparator module is configured to compare the input slope compensation voltage and error adjustment voltage, to generate a third control signal, and output the third control signal to the logic control unit; and

the Clk generation module is configured to generate a fixed frequency signal based on the input fixed reference voltage, and output the fixed frequency signal to the logic control unit.

Preferably, the Vramp generation module includes a first current source module, a second current source module, a third current source module, a fourth current source module, a first capacitor, a bias voltage source, and a switch transistor, wherein

current input ends of the first current source module, the second current source module, and the third current source module are separately connected to a power supply voltage end, and after current output ends of the first current source module, the second current source module, and the third current source module, after being connected in parallel to each other, are connected to the first capacitor and the switch transistor, and are connected to a current input end of the fourth current source module and an output end of the Vramp generation module; a current output end of the fourth current source module is connected to a ground potential end; an other end of the first capacitor is connected to an other end of the switch transistor in parallel, and is then connected to a positive electrode end of the bias voltage source, and a negative electrode end of the bias voltage source is connected to the ground potential end; and a control end of the switch transistor is connected to a control signal output end of the power-stage circuit unit; and

an output current of the first current source module is equal to the fixed current, and the current is independent of a temperature; an output current of the second current source module is directly proportional to the first sampled voltage; an output current of the third current source module is directly proportional to the power supply voltage; and an output current of the fourth current source module is directly proportional to the controllable reference voltage.

Preferably, the error amplifier module includes an operational amplifier module, a first resistor, a second capacitor, and a third capacitor, wherein

a first output end of the reference voltage and reference current module is connected to an in-phase input end of the operational amplifier module, a second sampled voltage output end of the output voltage sampling network module is connected to an out-phase input end of the operational amplifier module, at the same time, the out-phase input end of the operational amplifier module is connected to the first resistor and the second capacitor, an other end of the first resistor is connected to the third capacitor, an other end of the third capacitor is connected to an other end of the second capacitor in parallel, and is then connected to an output end of the operational amplifier module, and at the same time, the output end of the operational amplifier module is connected to an out-phase input end of the comparator module in the loop core module.

Preferably, in the Vramp generation module, when the fourth control signal controls the switch transistor to be turned on, the slope compensation voltage output by the switch transistor is clamped to an output potential of the bias voltage source and remains unchanged;

when the fourth control signal controls the switch transistor to be turned off, the slope compensation voltage output by the switch transistor starts to increase over time based on the output potential of the bias voltage source, and an increasing slope of the slope compensation voltage is related to the power supply voltage, the first sampled voltage, and the controllable reference voltage; and

in the loop core module, the Vramp generation module and the comparator module form a fast path, and the error amplifier module and the comparator module form a slow path.

Preferably, the logic control unit includes a comprehensive circuit unit and a logic core circuit unit, wherein

the comprehensive circuit unit includes a startup circuit, a PWM/PFM switching circuit, a positive over-current protection circuit, a negative over-current protection circuit, and an inductor current zero-crossing detection circuit; and the comprehensive circuit unit is used for startup and running mode control of the DC-DC converter, and related circuit protection; and

the logic core circuit unit is configured to form the first control signal and the second control signal through logic control based on an input controllable reference voltage, a frequency signal, a third control signal, and the second sampled voltage, and provide the first control signal and the second control signal to the power-stage circuit unit.

Preferably, the logic core circuit unit includes a minimum turn-on time module, a first RS trigger module, a second RS trigger module, a forced PWM module, a first logic OR gate, a logic AND gate, a first inverter, and a second inverter, wherein

an output end of the comparator module in the loop core module is connected to an input end of the minimum turn-on time module, and an output end of the minimum turn-on time module is connected to a second input end of the first logic OR gate; an inductor current limiting signal output end of the positive over-current protection circuit is connected to a first input end of the first logic OR gate; and an output end of the first logic OR gate is connected to an input end of the first RS trigger module; and

an enable end of the first RS trigger module and an enable end of the second RS trigger module are separately connected to an enable signal input end, and the input end of the first RS trigger module and an input end of the second RS trigger module are separately connected to an output end of a Clk generation module; an output end of the first RS trigger module is connected to an input end of the first inverter and an input end of the second inverter, and an output end of the first inverter is connected to the first control signal output end; an output end of the second inverter is connected to a first input end of the logic AND gate; and an output end of the forced PWM module is connected to the input end of the second RS trigger module, an output end of the second RS trigger module is connected to a second input end of the logic AND gate, and an output end of the logic AND gate is connected to the second control signal output end.

Preferably, the forced PWM module includes a hysteresis comparator module, a counter module, a third inverter, and a second logic OR gate, wherein

an in-phase input end of the hysteresis comparator module is connected to a second sampled voltage output end of an output voltage sampling network module, an out-phase input end of the hysteresis comparator module is connected to a first output end of a reference voltage and reference current module, an output end of the hysteresis comparator module is connected to an input end of the counter module, and an output end of the counter module is connected to a first input end of the second logic OR gate; an output end of the inductor current zero-crossing detection circuit is connected to an input end of the third inverter, and an output end of the third inverter is connected to a second input end of the second logic OR gate; and an output end of the second logic OR gate is connected to the input end of the second RS trigger module.

Preferably, when an output voltage of the DC-DC converter jumps from a high voltage to a low voltage, the controllable reference voltage rapidly decreases, the second sampled voltage is greater than the controllable reference voltage, the DC-DC converter switches to an FPWM working mode, and an NMOS power transistor discharges a ceramic capacitor with maximum turn-on time, to implement a rapid response to the output voltage of the DC-DC converter.

According to a second aspect of the embodiments of the present invention, an integrated circuit chip is provided. The chip includes the DC-DC converter.

According to a third aspect of the embodiments of the present invention, an electronic device is provided. The electronic device includes the DC-DC converter.

In comparison with the related art, by using a technical solution of performing weighted superposition on a power supply voltage, a sampled voltage, a controllable reference voltage, and a fixed current to form a slope compensation voltage, and a technical solution of FPWM/FCCM logic control, a DC-DC converter provided by the present invention controls maximum turn-on time or minimum turn-on time of a PMOS power transistor and an NMOS power transistor to charge and discharge an output capacitor based on an existing voltage-mode DC-DC converter structure without extending a bandwidth. In this way, fast tracking of an output voltage of the DC-DC converter in respect of transmission power is realized, thereby ensuring efficiency and greatly improving a transient conversion response speed of the output voltage. Therefore, the DC-DC converter provided by the present invention has beneficial effects such as a skillful and proper circuit design, a rapid response speed, and high efficiency, and better satisfies a high response speed requirement of a 5G communication system.

BRIEF DESCRIPTION OF THE DRAWINGS

FIG. 1(a) is a schematic diagram of a radio frequency front-end module using a constant power supply voltage architecture in an existing technical solution;

FIG. 1(b) is a schematic diagram of a radio frequency front-end module using an APT power supply voltage architecture in an existing technical solution;

FIG. 2 is a schematic diagram of a structure of a DC-DC converter according to an embodiment of the present invention;

FIG. 3 is a schematic diagram of a simplified circuit of a Vramp generation module 2230 according to an embodiment of the present invention;

FIG. 4 is a schematic diagram of a circuit of an error amplifier module 2240 according to an embodiment of the present invention;

FIG. 5 is a schematic diagram of a circuit of a logic control unit 2100 according to an embodiment of the present invention;

FIG. 6(a) is a timing waveform diagram of signals Clk, Vramp&Vea, PWM, and $D_P/D_N$, and $V_{CC}$ when an output voltage $V_{CC}$ jumps from 0.5 V to 3.4 V according to an embodiment of the present invention;

FIG. 6(b) is a timing waveform diagram of signals Clk, Vramp&Vea, PWM, and $D_P/D_N$, and $V_{CC}$ when an output voltage $V_{CC}$ jumps from 3.4 V to 0.5 V according to an embodiment of the present invention; and

FIG. 7 is a diagram of an example of an electronic device using a DC-DC converter according to the present invention.

## DETAILED DESCRIPTION

The technical solutions of the present invention are described below in more detail with reference to the accompanying drawings and specific embodiments.

For ease of understanding and description, in the present invention, a radio frequency front-end module using an APT mode in an existing technical solution is first briefly described, and a specific technical solution of this embodiment of the present invention is described in detail on such a basis.

As shown in FIG. 1(b), the radio frequency front-end module using an APT mode includes four parts: a baseband, a radio frequency integrated circuit (RFIC), a buck DC-DC converter, and a power amplifier (PA). The baseband outputs a corresponding control signal (code) to the DC-DC converter based on output radio frequency signal power. The DC-DC converter automatically adjusts an output voltage $V_{CC}$ after receiving the control signal, to provide a supply voltage for the power amplifier. In a case of low baseband radio frequency signal power, the APT mode can improve efficiency of the power amplifier. However, in an architecture of the radio frequency front-end module using an APT mode, there are problems such as a low response speed of a voltage-mode DC-DC converter and poor stability due to a high loop bandwidth.

To resolve the foregoing problem existing in the related art, in the present invention, by using a corresponding technology means, fast tracking of the output voltage $V_{CC}$ in respect of transmission power is realized based on the existing voltage-mode DC-DC converter structure without extending the loop bandwidth, thereby ensuring high efficiency, and greatly improving a transient conversion response speed of the output voltage $V_{CC}$. Detailed and specific descriptions are provided below.

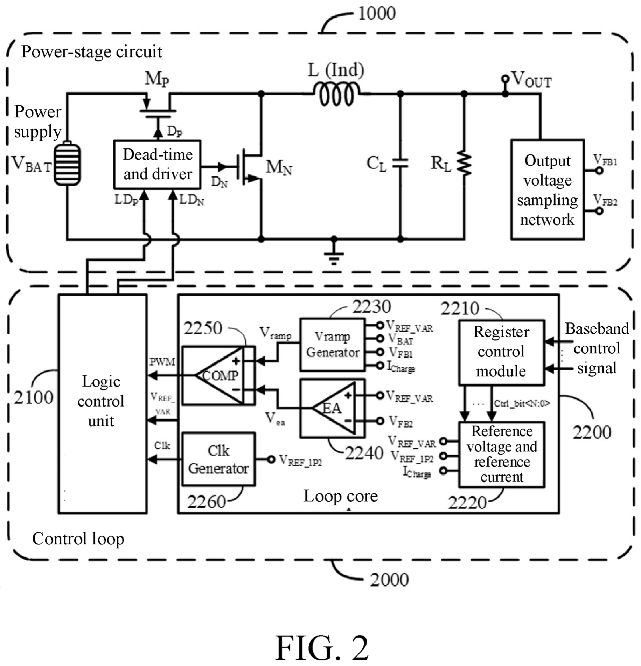

As shown in FIG. 2, the present invention provides a DC-DC converter, including a power-stage circuit unit 1000 and a control loop unit 2000. A control signal output end of a baseband is connected to an input end of the control loop unit 2000, and control signal output ends $LD_P$ and $LD_N$ of the control loop unit 2000 are respectively connected to corresponding input ends of the power-stage circuit unit 1000, and a first sampled voltage output end and a second sampled voltage output end of the power-stage circuit unit 1000 are respectively connected to corresponding input ends of the control loop unit 2000, to form a closed control loop.

The power-stage circuit unit 1000 includes a power supply module $V_{BAT}$, a dead-time and driver module (Dead-Time & Drivers), an output voltage sampling network module ($V_{OUT}$ Sample Block), a PMOS power switch transistor $M_P$, an NMOS power switch transistor $M_N$, a load resistor $R_L$, a power inductor L, and a ceramic capacitor $C_L$. A first input end and a second input end of the dead-time and driver module are separately connected to the control signal output ends $LD_P$ and $LD_N$ of the control loop unit 2000, a first output end of the dead-time and driver module is connected to a gate of the PMOS power switch transistor $M_P$, and a second output end of the dead-time and driver module is connected to a gate of the NMOS power switch transistor $M_N$; a source of the PMOS power switch transistor $M_P$ is connected to a positive electrode of the power supply module $V_{BAT}$, and a negative electrode of the power supply module $V_{BAT}$ is connected to a ground potential end; a drain of the PMOS power switch transistor $M_P$ is connected to a drain of the NMOS power switch transistor $M_N$ and the power inductor L, and a source of the NMOS power switch transistor $M_N$ is connected to the ground potential end; another end of the power inductor L is connected to the load resistor $R_L$, the ceramic capacitor $C_L$, and a voltage output end $V_{OUT}$, and another end of the load resistor $R_L$ and another end of the ceramic capacitor $C_L$ are both connected to the ground potential end; and an input end of the output voltage sampling network module is connected to the voltage output end $V_{OUT}$, and a first sampled voltage output end and a second sampled voltage output end of the output voltage sampling network module are respectively connected to corresponding input ends of the control loop unit 2000.

The PMOS power switch transistor $M_P$ and the NMOS power switch transistor $M_N$ are on-chip elements, and the output voltage sampling network module and the dead-time and driver module are on-chip modules; and the load resistor $R_L$, the power inductor L, the ceramic capacitor $C_L$, and the power supply module $V_{BAT}$ are off-chip elements.

In the power-stage circuit unit 1000, after receiving the control signals $LD_P$ and $LD_N$ output by the control loop unit 2000, the dead-time and driver module generates corresponding control signals $D_P$ and $D_N$, to control a turned-on state and a turned-off state of the power switch transistors $M_P$ and $M_N$, and ensure that the power switch transistors $M_P$ and $M_N$ are not turned on at the same time. The power supply voltage $V_{BAT}$ is chopped by the power switch transistors $M_P$ and $M_N$, and is then filtered by an LC filter circuit including the power inductor L and the ceramic capacitor $C_L$. After filtering, a stable DC voltage $V_{OUT}$ (that is, $V_{CC}$) is output from an output end of the power-stage circuit unit. The output voltage sampling network module samples the output voltage $V_{OUT}$, and then outputs two sampled voltages $V_{FB1}$ and $V_{FB2}$ to the control loop unit 2000.

The control loop unit 2000 includes a logic control unit 2100 and a loop core module 2200. Three signal (that is, a controllable reference voltage $V_{REF\_VAR}$, a control signal PWM, and a frequency signal Clk) output ends of the loop core module 2200 are respectively connected to corresponding input ends of the logic control unit 2100.

The loop core module 2200 includes a register control module 2210, a reference voltage and reference current module (Vbg & IBIAS) 2220, a Vramp generation module (Vramp Generator) 2230, an error amplifier module (EA) 2240, a comparator module (COMP) 2250, and a Clk generation module (Clk Generator) 2260. The control signal output end of the baseband is connected to an input end of the register control module 2210; a voltage output end of the power supply module $V_{BAT}$ is connected to a first input end of the Vramp generation module 2230, and the first sampled voltage output end of the output voltage sampling network module is connected to a second input end of the Vramp generation module 2230; and the second sampled voltage output end of the output voltage sampling network module is connected to a first input end of the error amplifier module 2240. An output end of the register control module 2210 is connected to an input end of the reference voltage and reference current module 2220, and a first output end of the reference voltage and reference current module 2220 is separately connected to a third input end of the Vramp generation module 2230 and a second input end of the error amplifier module 2240, and is connected to a first input end of the logic control unit 2100; a second output end of the reference voltage and reference current module 2220 is connected to an input end of the Clk generation module 2260, and a third output end of the reference voltage and reference current module 2220 is connected to a fourth input end of the Vramp generation module 2230; an output end of the Vramp generation module 2230 is connected to an in-phase input end of the comparator module 2250, and an output end of the error amplifier module 2240 is connected to an out-phase input end of the comparator module 2250; an output end of the comparator module 2250 is connected to a second input end of the logic control unit 2100; and an output end of the Clk generation module 2260 is connected to a third input end of the logic control unit 2100.

The register control module 2210 is an MIPI module, and is configured to receive a control signal from the baseband, convert the control signal into a control signal Ctrl_bit<N:0>, and output the control signal Ctrl_bit<N:0> to the reference voltage and reference current module 2220.

The reference voltage and reference current module 2220 is configured to generate a corresponding controllable reference voltage $V_{REF\_VAR}$, fixed reference voltage $V_{REF\_1P2}$, and fixed current $I_{Charge}$ based on the input control signal Ctrl_bit<N:0>. The controllable reference voltage $V_{REF\_VAR}$ is separately output to the Vramp generation module 2230, the error amplifier module 2240, and the logic control unit 2100, the fixed reference voltage $V_{REF\_1P2}$ is output to the Clk generation module 2260, and the fixed current $I_{Charge}$ is output to the Vramp generation module 2230.

The Vramp generation module 2230 is configured to generate a slope compensation voltage Vramp based on the input controllable reference voltage $V_{REF\_VAR}$ and fixed current $I_{Charge}$, the sampled voltage $V_{FB1}$, and the power supply voltage $V_{BAT}$, and output the slope compensation voltage Vramp to the comparator module 2250.

The error amplifier module 2240 is configured to output an error adjustment voltage Vea to the comparator module 2250 through difference amplification based on the input controllable reference voltage $V_{REF\_VAR}$ and the sampled voltage $V_{FB2}$.

The comparator module 2250 is configured to compare the input slope compensation voltage Vramp and error adjustment voltage Vea, to generate the control signal PWM (Pulse Width Modulation), and output the control signal PWM to the logic control unit 2100.

The Clk generation module 2260 is configured to: generate a fixed frequency signal Clk based on the input fixed reference voltage $V_{REF\_1P2}$, and output the fixed frequency signal Clk to the logic control unit 2100.

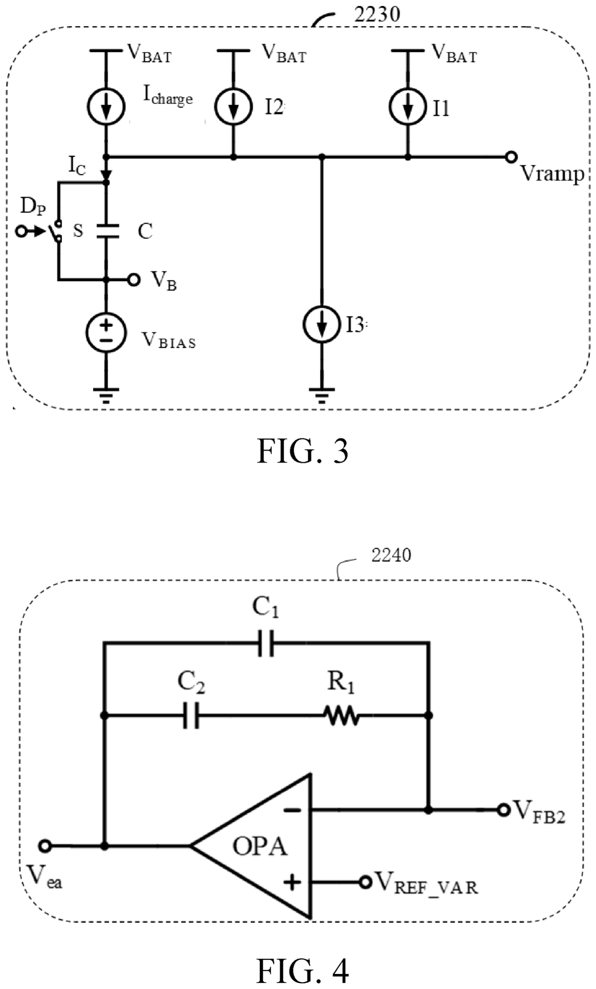

As shown in FIG. 3, in an embodiment of the present invention, the Vramp generation module 2230 includes a first current source module $I_{Charge}$, a second current source module I1, a third current source module I2, a fourth current source module I3, a first capacitor C, a bias voltage source $V_{BIAS}$, and a switch transistor S. Current input ends of the first current source module $I_{Charge}$, the second current source module I1, and the third current source module I2 are separately connected to a power supply voltage end $V_{BAT}$, and after being connected in parallel to each other, current output ends of the first current source module $I_{Charge}$, the second current source module I1, and the third current source module I2 are together connected to the first capacitor C and the switch transistor S, and are connected to a current input end of the fourth current source module I3 and an output end Vramp of the Vramp generation module; a current output end of the fourth current source module I3 is connected to the ground potential end; an other end of the first capacitor C is connected to an other end of the switch transistor S in parallel, and is then connected to a positive electrode end of the bias voltage source $V_{BIAS}$, and a negative electrode end of the bias voltage source $V_{BIAS}$ is connected to the ground potential end; and a control end of the switch transistor S is connected to a control signal end $D_P$.

An output current of the first current source module $I_{Charge}$ is equal to an output current $I_{Charge}$ of the reference voltage and reference current module 2220, and the current is independent of a temperature; an output current of the second current source module I1 is directly proportional to the sampled voltage $V_{FB1}$, where I1=k1*$V_{FB1}$; an output current of the third current source module I2 is directly proportional to the power supply voltage $V_{BAT}$, where I2=k2*$V_{BAT}$; an output current of the fourth current source module I3 is directly proportional to the controllable reference voltage $V_{REF\_VAR}$, where I3=k3*$V_{REF\_VAR}$; and k1, k2, and k3 are proportionality coefficients.

When the control signal $D_p$ controls the switch transistor S to be turned on, the output voltage Vramp is clamped to an output potential $V_B$ of the bias voltage source $V_{BIAS}$ and remains unchanged.

When the control signal $D_p$ controls the switch transistor S to be turned off, a charging current $I_C$ of the first capacitor C is:

$$I_C = I_{charge} + I1 + I2 - I3 \qquad (1)$$

The output voltage Vramp starts to increase over time t based on the potential $V_B$. In this case, the output voltage Vramp is:

$$Vramp = V_B + (I_C/C) \times t \qquad (2)$$

It can be known from formula 1 and formula 2 that, an increasing slope of the output voltage Vramp is related to the charging current $I_C$. In other words, the increasing slope of the output voltage Vramp is related to the power supply voltage $V_{BAT}$, the sampled voltage $V_{FB1}$, and the controllable reference voltage $V_{REF\_VAR}$.

As shown in FIG. 4, in an embodiment of the present invention, the error amplifier module 2240 is an error amplifier using a PI compensation loop, and includes an operational amplifier (OPA) module, a first resistor $R_1$, a second capacitor $C_1$, and a third capacitor $C_2$. A first output end of the reference voltage and reference current module 2220 (that is, a controllable reference voltage $V_{REF\_VAR}$ output end) is connected to an in-phase input end of the operational amplifier module, the second sampled voltage output end of the output voltage sampling network module is connected to an out-phase input end of the operational amplifier module, at the same time, the out-phase input end of the operational amplifier module is connected to the first resistor $R_1$ and the second capacitor $C_1$, an other end of the first resistor $R_1$ is connected to the third capacitor $C_2$, an other end of the third capacitor $C_2$ is connected to an other end of the second capacitor $C_1$ in parallel, and is then connected to an output end of the operational amplifier module, and at the same time, the output end of the operational amplifier module is connected to an out-phase input end of the comparator module 2250.

In the error amplifier module 2240, the input end of the operational amplifier module receives the controllable reference voltage $V_{REF\_VAR}$ and the sampled voltage $V_{FB2}$, performs difference amplification, and outputs the error adjustment voltage Vea. A function of the error adjustment voltage Vea in the entire control loop of the DC-DC converter is to clamp the sampled voltage $V_{FB2}$ to the controllable reference voltage $V_{REF\_VAR}$, to ensure that an output DC voltage of the DC-DC converter satisfies $V_{OUT} = K \times V_{REF\_VAR}$, where K is a proportionality coefficient. In other words, the output voltage $V_{OUT}$ of the DC-DC converter can track transmission power.

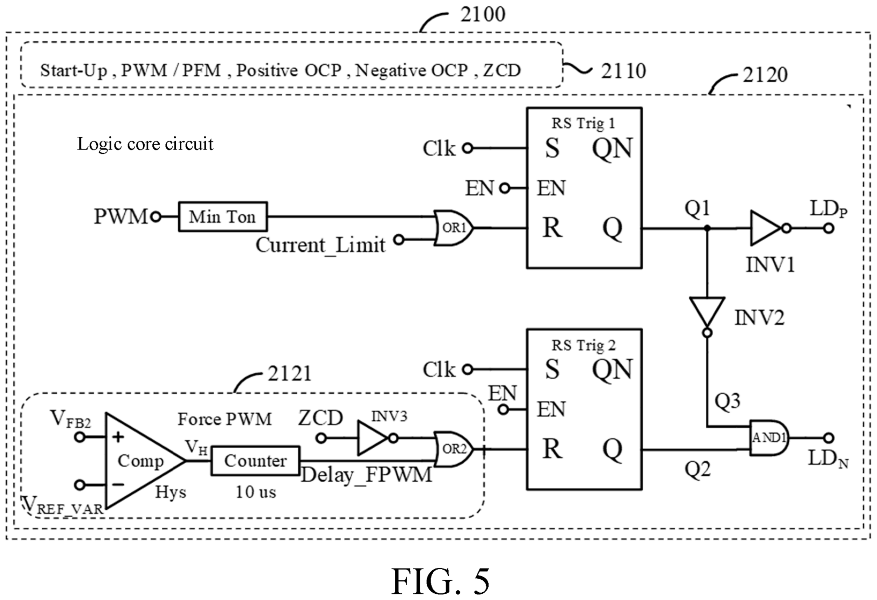

As shown in FIG. 5, in an embodiment of the present invention, the logic control unit 2100 includes a comprehensive circuit unit 2110 and a logic core circuit unit 2120. The control signal $LD_P$ and the control signal $LD_N$ are generated and output by the logic core circuit unit 2120.

The comprehensive circuit unit 2110 includes a startup circuit (Start_Up), a PWM/PFM switching circuit, a positive over-current protection circuit (Positive OCP), a negative over-current protection circuit (Negative OCP), and an inductor current zero-crossing detection circuit (ZCD). When an enable signal satisfies EN=1, the startup circuit starts to work, and the buck DC-DC converter enters a startup stage, and automatically enters a normal working state. In this case, the buck DC-DC converter automatically adjusts a working mode based on a load current, that is, automatically selects a PWM working mode or a PFM working mode. Specific circuits of protection or control functional units in the comprehensive circuit unit 2110 may be implemented by using corresponding circuits in the related art. This is not described in detail in the present invention.

The logic core circuit unit 2120 includes a minimum turn-on time (Min Ton) module, a first RS trigger (RS Trig1) module, a second RS trigger (RS Trig2) module, a forced PWM (Force PWM) module 2121, a first logic OR gate OR1, a logic AND gate AND1, a first inverter INV1, and a second inverter INV2. The forced PWM module 2121 includes a hysteresis comparator (Comp) module, a counter (Counter) module, a third inverter INV3, and a second logic OR gate OR2.

In a circuit structure of the logic core circuit unit 2120, connection relationships between modules and logic units are as follows.

In the forced PWM module 2121, an in-phase input end of the hysteresis comparator module is connected to the second sampled voltage output end of the output voltage sampling network module, an out-phase input end of the hysteresis comparator module is connected to a first output end of the reference voltage and reference current module 2220 (that is, the controllable reference voltage $V_{REF\_VAR}$ output end), an output end of the hysteresis comparator module is connected to an input end of a counter module, and an output end of the counter module is connected to a first input end of the second logic OR gate OR2; an output end of the inductor current zero-crossing detection circuit (that is, the ZCD) is connected to an input end of the third inverter INV3, and an output end of the third inverter INV3 is connected to a second input end of the second logic OR gate OR2; and an output end of the second logic OR gate OR2 is connected to an input end R of the second RS trigger module.

An output end of the comparator module 2250 in the loop core module 2200 is connected to an input end of the minimum turn-on time module, and an output end of the minimum turn-on time module is connected to a second input end of the first logic OR gate OR1; a Current_Limit signal output end of the positive over-current protection circuit is connected to a first input end of the first logic OR gate OR1; and an output end of the first logic OR gate OR1 is connected to an input end R of the first RS trigger module.

An input end EN of the first RS trigger module and an input end EN of the second RS trigger module are separately connected to an enable signal input end EN, and an input end S of the first RS trigger module and an input end S of the second RS trigger module are separately connected to an output end of the Clk generation module 2260; and an output end Q of the first RS trigger module is connected to an input end of the first inverter INV1 and an input end of the second inverter INV2, and an output end of the first inverter INV1 is connected to a control signal $LD_P$ output end. An output end of the second inverter INV2 is connected to a first input end of the logic AND gate AND1. An output end Q of the second RS trigger module is connected to a second input end of the logic AND gate AND1. An output end of the logic AND gate AND1 is connected to a control signal $LD_N$ output end.

In an embodiment of the present invention, a logical relationship generated by the control signal $LD_P$ and the control signal $LD_N$ that are output by the logic core circuit unit 2120 is as follows.

After the control signal PWM passes through the minimum turn-on time module, a logic OR operation is performed on the control signal PWM and the inductor current limiting signal Current_Limit. An output signal obtained after the logic OR operation is input to a reset end (that is, an R end) of the RS trigger module, the frequency signal Clk is input to a set end (that is, an S end) of the RS trigger module, and an enable signal EN is input to an enable end (that is, an EN end) of the RS trigger module. After a Q-end output signal (that is, a signal Q1) of the RS trigger module passes through the inverter, the control signal $LD_P$ is obtained. At the same time, a signal Q3 is obtained after the signal Q1 passes through another inverter.

The controllable reference voltage $V_{REF\_VAR}$ is compared with the sampled voltage $V_{FB2}$ through a comparator, after a compared output signal $V_H$ passes through the counter, the logic OR operation is performed on the output signal $V_H$ and an output signal obtained after an output signal of the inductor current zero-crossing detection circuit (ZCD) passes through the inverter. An output signal obtained after the logic OR operation is input to a reset end of another RS trigger module, the frequency signal Clk is input to a set end of the RS trigger module, and the enable signal EN is input to an enable end of the RS trigger module. A logic AND operation is performed on a Q-end output signal (that is, a signal Q2) of the RS trigger module and the signal Q3, and an output signal obtained after the logic AND operation is the control signal $LD_N$.

The following describes in detail, with reference to a timing waveform diagram of each related voltage signal and control signal in the control loop, a working principle of realizing voltage tracking and a rapid response in respect of the DC-DC converter provided in this embodiment of the present invention.

Main related control signals used in the following analysis and description include the frequency signal Clk, the control signal PWM, the control signal $D_P$, and the control signal $D_N$, and main related voltage signals include the slope compensation voltage Vramp, the error adjustment voltage Vea, and the output voltage $V_{CC}$ (that is, $V_{OUT}$) of the DC-DC converter.

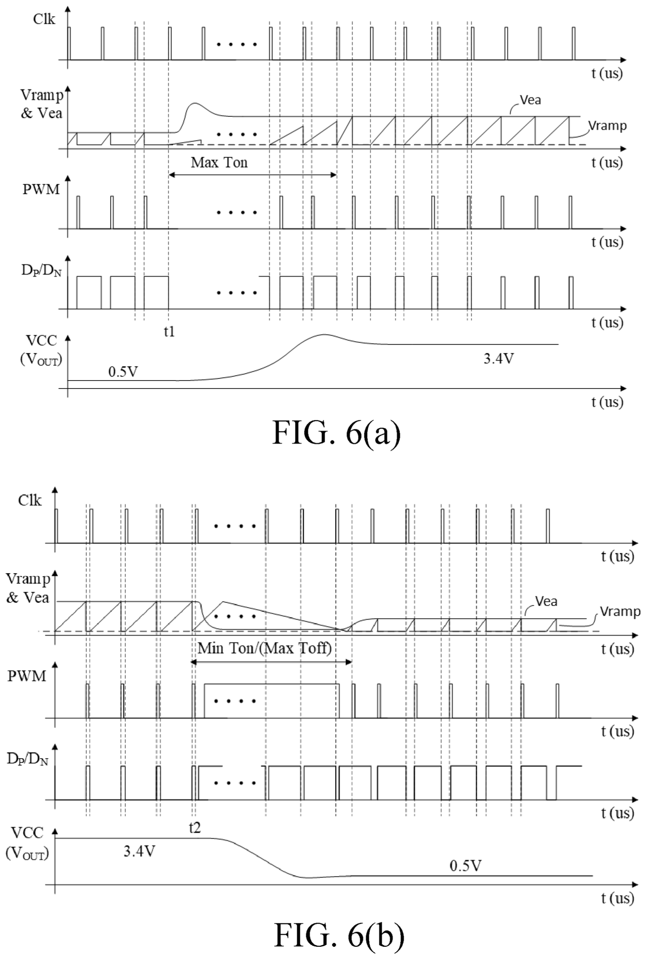

As shown in FIG. 6(a), when the output voltage $V_{CC}$ of the DC-DC converter jumps from Vmin=0.5 V to Vmax=3.4 V, a transient waveform change of the signals Clk, Vramp&Vea, PWM, and $D_P/D_N$, and $V_{CC}$ is shown in FIG. 6(a).

Before a moment t1, the DC-DC converter is in a stable working state. In this case, periodic switching of the control signal PWM and the control signal Clk that are generated after comparison is performed on the slope compensation voltage Vramp and the error adjustment voltage Vea ensures a normal output of the output voltage $V_{CC}$. A periodic pulse signal of the control signal Clk ensures that a power transistor $M_P$ is controlled to be periodically turned on, and a power transistor $M_N$ is controlled to be periodically turned off. A periodic pulse signal of the control signal PWM ensures that the power transistor $M_N$ is controlled to be periodically turned on, and the power transistor $M_P$ is controlled to be periodically turned off. In a switching period Ts of the stage, fixed turn-on time Ton of the power transistor $M_P$ ensures that the output voltage satisfies VCC=(Ton/Ts)$^x$V$_{BAT}$.

At the moment t1, the register control module 2210 in the loop core module 2200 receives a control signal code from the baseband, converts the control signal code into a control signal Ctrl_bit<N:0>, and inputs the control signal Ctrl_bit<N:0> to the reference voltage and reference current module 2220. The reference voltage and reference current module 2220 outputs a corresponding controllable reference voltage $V_{REF\_VAR}$ based on the control signal Ctrl_bit< N:0>. In this case, the control signal Ctrl_bit< N:0> jumps from a low control word to a high control word, and the controllable reference voltage $V_{REF\_VAR}$ correspondingly jumps from a low voltage to a high voltage. Because an output current of the current source module I3 in the Vramp generation module 2230 is directly proportional to the controllable reference voltage $V_{REF\_VAR}$, it can be known from formula 1 and formula 2 that, the increasing slope of the slope compensation voltage Vramp rapidly decreases. Therefore, in several periods after the moment t1, although the control signal Clk still periodically turns on the power transistor $M_P$, the slope compensation voltage Vramp cannot exceed the error adjustment voltage Vea in the turn-on time of the power transistor $M_P$. Therefore, the control signal PWM obtained after comparison is performed on the slope compensation voltage Vramp and the error adjustment voltage Vea is maintained at a low level in the several periods. The power transistor $M_P$ charges an output capacitor $C_L$ with maximum turn-on time, and the power transistor $M_N$ discharges the output capacitor $C_L$ with minimum turn-on time, so that the output voltage $V_{CC}$ rapidly increases and reaches a steady state.

As shown in FIG. 6(b), when the output voltage $V_{CC}$ of the DC-DC converter jumps from Vmax=3.4 V to Vmin=0.5 V, a transient waveform change of the signals Clk, Vramp&Vea, PWM, and $D_P/D_N$, and $V_{CC}$ is shown in FIG. 6(b).

Before t2, the DC-DC converter is in a stable working state. In this case, periodic switching of the control signal PWM and the control signal Clk that are generated after comparison is performed on the slope compensation voltage Vramp and the error adjustment voltage Vea ensures a normal output of the output voltage $V_{CC}$. A periodic pulse signal of the control signal Clk ensures that a power transistor $M_P$ is controlled to be periodically turned on, and a power transistor $M_N$ is controlled to be periodically turned off. A periodic pulse signal of the control signal PWM ensures that the power transistor $M_N$ is controlled to be periodically turned on, and the power transistor $M_P$ is controlled to be periodically turned off. In a switching period Ts of the stage, fixed turn-on time Ton of the power transistor $M_P$ ensures that the output voltage satisfies VCC=(Ton/Ts)×$V_{BAT}$.

At the moment t2, the register control module 2210 in the loop core module 2200 receives a control signal code from the baseband, converts the control signal code into a control signal Ctrl_bit<N:0>, and inputs the control signal Ctrl_bit<N:0> to the reference voltage and reference current module 2220. The reference voltage and reference current module 2220 outputs a corresponding controllable reference voltage $V_{REF\_VAR}$ based on the control signal Ctrl_bit< N:0>. In this case, the control signal Ctrl_bit< N:0> jumps from a high control word to a low control word, and the controllable reference voltage $V_{REF\_VAR}$ correspondingly jumps from a high voltage to a low voltage. Because an output current of the current source module I3 in the Vramp generation module 2230 is directly proportional to the controllable reference voltage $V_{REF\_VAR}$, it can be known from formula 1 and formula 2 that, the increasing slope of the slope compensation voltage Vramp rapidly increases. Therefore, in several periods after the moment t2, the control signal Clk still periodically turns on the power transistor $M_P$, but the slope compensation voltage Vramp rapidly exceeds the error adjustment voltage Vea in the turn-on time of the power transistor $M_P$. Therefore, the control signal PWM obtained after comparison is performed on the slope compensation voltage Vramp and the error adjustment voltage Vea is changed from a low level to a high level, and is maintained at the high level in the several periods. The power transistor $M_P$ charges an output capacitor $C_L$ with the minimum turn-on time, and the power transistor $M_N$ discharges the output capacitor $C_L$ with the maximum turn-on time. At the same time, the forced PWM module 2121 in the logic core circuit unit 2120 operates for a short period of time, so that the output voltage $V_{CC}$ rapidly decreases and reaches a steady state.

A working principle of the forced PWM module 2121 is as follows.

When the DC-DC converter is in a normal working state, the sampled voltage $V_{FB2}$ is less than the controllable reference voltage $V_{REF\_VAR}$, an output signal $V_H$ of the hysteresis comparator and an output signal Delay_FPWM of the counter are both at a low level. In this case, an output signal of the second logic OR gate OR2 is controlled by a ZCD signal of the inductor current zero-crossing detection circuit.

When the output voltage $V_{CC}$ of the DC-DC converter jumps from a high voltage to a low voltage, correspondingly, the controllable reference voltage $V_{REF\_VAR}$ rapidly decreases, so that the sampled voltage $V_{FB2}$ is greater than the controllable reference voltage $V_{REF\_VAR}$. Therefore, the output signal $V_H$ of the hysteresis comparator is changed to a high level, triggering the counter to start counting. In addition, the output signal Delay_FPWM of the counter is also changed to a high level, so that the output signal of the second logic OR gate OR2 is directly set to a high level. In this case, the DC-DC converter is in an FPWM working mode, and the NMOS power transistor $M_N$ discharges the ceramic capacitor ($C_L$) with the maximum turn-on time, so that the output voltage $V_{CC}$ rapidly decreases. When the sampled voltage $V_{FB2}$ is less than the controllable reference voltage $V_{REF\_VAR}$ again, the output signal $V_H$ of the hysteresis comparator and the output signal Delay_FPWM of the counter are changed to a low level, and are restored to the normal working state.

In conclusion, by using a transient feature of the controllable reference voltage $V_{REF\_VAR}$, the DC-DC converter provided in the present invention performs weighted superposition on the power supply voltage $V_{BAT}$, the sampled voltage $V_{FB}$, the controllable reference voltage $V_{REF\_VAR}$, and the current $I_{Charge}$ to form the slope compensation voltage Vramp based on the existing voltage-mode DC-DC converter structure without extending the bandwidth. In the loop core module 2200, the Vramp generation module 2230 and the comparator module 2250 form a fast path, and the error amplifier module 2240 and the comparator module 2250 form a slow path. At the same time, an FPWM/FCCM logic control function of the logic control unit is combined. Fast tracking of the output voltage $V_{CC}$ (that is, $V_{OUT}$) of the DC-DC converter in respect of the transmission power is realized by controlling the maximum turn-on time or the minimum turn-on time of the power transistor $M_P$ and the power transistor $M_N$ to charge and discharge the output capacitor $C_L$. In this way, the transient conversion response speed of the output voltage $V_{CC}$ is greatly improved.

An embodiment of the present invention further provides an integrated circuit chip. The chip includes the DC-DC converter circuit provided by the present invention. The integrated circuit chip is used in a wireless communication system for providing a DC power supply for a radio frequency front-end module, and in a radio frequency front-end module architecture using an APT mode, fast tracking of an output voltage $V_{CC}$ in respect of transmission power can be realized. For a specific structure based on the DC-DC converter circuit in the chip, details are not described herein again.

In addition, the DC-DC converter provided by the present invention may further be used in an electronic device, as an important component of a radio frequency assembly. The electronic device described herein is a communication device that may be used in a mobile environment and support various communication standards such as GSM, EDGE, TD_SCDMA, TDD_LTE, and FDD_LTE, and includes a mobile phone, a notebook computer, a tablet computer, an in-vehicle computer, and the like. In addition, the technical solutions provided in the embodiments of the present invention are also applicable to other application scenarios of analog integrated circuits, such as a communication base station and an intelligent connected vehicle.

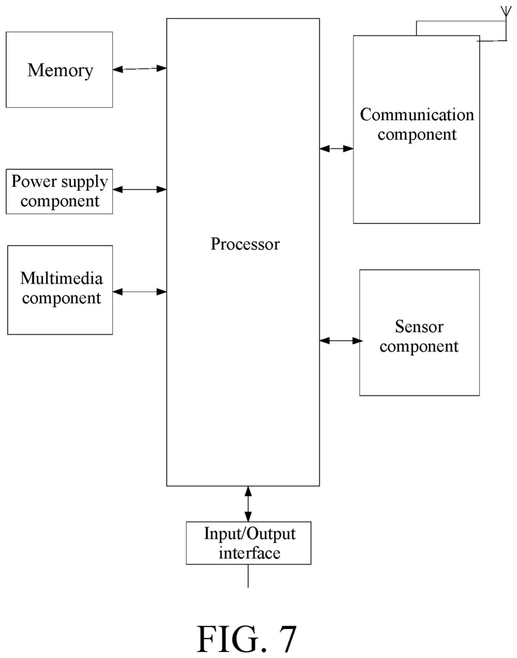

As shown in FIG. 7, the electronic device includes at least a processor and a memory, and may further include a communication component, a sensor component, a power supply component, a multimedia component, and an input/output interface based on an actual requirement. The memory, the communication component, the sensor component, the power supply component, the multimedia component, and the input/output interface are all connected to the processor. The memory may be a static random access memory (SRAM), an electrically erasable programmable read-only memory (EPROM), an erasable programmable read-only memory (EPROM), a programmable read-only memory (PROM), a read-only memory (ROM), a magnetic memory, a flash memory, and the like, and the processor may be a central processing unit (CPU), a graphics processing unit (GPU), a field-programmable gate array (FPGA), an application-specific integrated circuit (ASIC), a digital signal processing (DSP) chip, and the like. Other communication components, sensor components, power supply components, multimedia components, and the like may all be implemented by using common components. Details are not specifically described herein.

In comparison with the related art, by using the technical solution of performing weighted superposition on the power supply voltage $V_{BAT}$, the sampled voltage $V_{FB}$, the controllable reference voltage $V_{REF\_VAR}$, and the current $I_{Charge}$ to form the slope compensation voltage Vramp, and the technical solution of FPWM/FCCM logic control, the DC-DC converter provided by the present invention controls the maximum turn-on time or the minimum turn-on time of the power transistor $M_P$ and the power transistor $M_N$ to charge and discharge the output capacitor $C_L$ based on the existing voltage-mode DC-DC converter structure without extending the bandwidth. In this way, the fast tracking of the output voltage $V_{CC}$ of the DC-DC converter in respect of the transmission power is realized, thereby ensuring efficiency and greatly improving the transient conversion response speed of the output voltage $V_{CC}$. Therefore, the DC-DC converter provided by the present invention has beneficial effects such as a skillful and proper circuit design, a rapid response speed, and high efficiency, and better satisfies a high response speed requirement of a 5G communication system.

The foregoing describes the DC-DC converter, the chip, and the corresponding electronic device provided by the present invention in detail. Any obvious modifications made by a person skilled in the art without departing from the substantive content of the present invention shall fall within the protection scope of the claims of this patent.

**Claims**

1. A DC-DC converter, comprising a power-stage circuit unit, and further comprising a control loop unit, wherein

   a first control signal output end and a second control signal output end of the control loop unit are separately connected to the power-stage circuit unit, and a first sampled voltage output end and a second sampled voltage output end of the power-stage circuit unit are separately connected to the control loop unit, to form a closed control loop;
   the control loop unit generates a first control signal and a second control signal based on a baseband control signal of a radio frequency front-end module, a first sampled voltage, and a second sampled voltage, and provides the first control signal and the second control signal to the power-stage circuit unit; and
   the power-stage circuit unit adjusts an output voltage based on the first control signal and the second control signal, to implement fast tracking of the output voltage of the DC-DC converter in respect of transmission power.

2. The DC-DC converter according to claim 1, wherein

   the power-stage circuit unit comprises a power supply module, a dead-time and driver module, an output voltage sampling network module, a PMOS power switch transistor, an NMOS power switch transistor, a load resistor, a power inductor, and a ceramic capacitor, wherein
   a first input end and a second input end of the dead-time and driver module are separately connected to the control signal output ends of the control loop unit, a first output end of the dead-time and driver module is connected to a gate of the PMOS power switch transistor, and a second output end of the dead-time and driver module is connected to a gate of the NMOS power switch transistor; a source of the PMOS power switch transistor is connected to a positive electrode of the power supply module, and a negative electrode of the power supply module is connected to a ground potential end; a drain of the PMOS power switch transistor is connected to a drain of the NMOS power switch transistor and the power inductor, and a source of the NMOS power switch transistor is connected to the ground potential end; another end of the power inductor is connected to the load resistor, the ceramic capacitor, and a voltage output end, and another end of the load resistor and another end of the ceramic capacitor are both connected to the ground potential end; and an input end of the output voltage sampling network module is connected to the voltage output end, and a first sampled voltage output end and a second sampled voltage output end of the output voltage sampling network module are respectively connected to corresponding input ends of the control loop unit; and

the dead-time and driver module is configured to generate a corresponding fourth control signal and fifth control signal based on the input first control signal and second control signal, to control a turned-on state and a turned-off state of the PMOS power switch transistor and the NMOS power switch transistor.

3. The DC-DC converter according to claim 1, wherein

the control loop unit comprises a logic control unit and a loop core module, wherein
a control signal output end of a baseband, and the first sampled voltage output end and the second sampled voltage output end of the power-stage circuit unit are respectively connected to corresponding input ends of the loop core module;
a controllable reference voltage output end, a third control signal output end, and a frequency signal output end of the loop core module are respectively connected to corresponding input ends of the logic control unit; and
a control signal output end of the logic control unit is connected to an input end of the power-stage circuit unit.

4. The DC-DC converter according to claim 3, wherein

the loop core module comprises a register control module, a reference voltage and reference current module, a Vramp generation module, an error amplifier module, a comparator module, and a Clk generation module, wherein
the register control module is configured to receive a control signal from the baseband, convert the control signal into a sixth control signal, and output the sixth control signal to the reference voltage and reference current module;
the reference voltage and reference current module is configured to generate a corresponding controllable reference voltage, fixed reference voltage, and fixed current based on the input sixth control signal, wherein the controllable reference voltage is separately output to the Vramp generation module, the error amplifier module, and the logic control unit, the fixed reference voltage is output to the Clk generation module, and the fixed current is output to the Vramp generation module;
the Vramp generation module is configured to generate a slope compensation voltage based on the input controllable reference voltage and fixed current, the first sampled voltage, and a power supply voltage, and output the slope compensation voltage to the comparator module;
the error amplifier module is configured to output an error adjustment voltage to the comparator module through difference amplification based on the input controllable reference voltage and the second sampled voltage;
the comparator module is configured to compare the input slope compensation voltage and error adjustment voltage, to generate a third control signal, and output the third control signal to the logic control unit; and
the Clk generation module is configured to generate a fixed frequency signal based on the input fixed reference voltage, and output the fixed frequency signal to the logic control unit.

5. The DC-DC converter according to claim 4, wherein

in the loop core module, the control signal output end of the baseband is connected to an input end of the register control module, a voltage output end of the power supply module is connected to a first input end of the Vramp generation module, a first sampled voltage output end of the output voltage sampling network module is connected to a second input end of the Vramp generation module, and a second sampled voltage output end of the voltage sampling network module is connected to a first input end of the error amplifier module;
an output end of the register control module is connected to an input end of the reference voltage and reference current module, and a first output end of the reference voltage and reference current module is separately connected to a third input end of the Vramp generation module and a second input end of the error amplifier module, and is connected to a first input end of the logic control unit; a second output end of the reference voltage and reference current module is connected to an input end of the Clk generation module, and a third output end of the reference voltage and reference current module is connected to a fourth input end of the Vramp generation module; and an output end of the Vramp generation module is connected to an in-phase input end of the comparator module, and an output end of the error amplifier module is connected to an out-phase input end of the comparator module; and

an output end of the comparator module is connected to a second input end of the logic control unit, and an output end of the Clk generation module is connected to a third input end of the logic control unit.

6. The DC-DC converter according to claim 4, wherein

the Vramp generation module comprises a first current source module, a second current source module, a third current source module, a fourth current source module, a first capacitor, a bias voltage source, and a switch transistor, wherein

current input ends of the first current source module, the second current source module, and the third current source module are separately connected to a power supply voltage end, and after current output ends of the first current source module, the second current source module, and the third current source module, after being connected in parallel to each other, are connected to the first capacitor and the switch transistor, and are connected to a current input end of the fourth current source module and an output end of the Vramp generation module; a current output end of the fourth current source module is connected to a ground potential end; another end of the first capacitor is connected to an other end of the switch transistor in parallel, and is then connected to a positive electrode end of the bias voltage source, and a negative electrode end of the bias voltage source is connected to the ground potential end; and a control end of the switch transistor is connected to a control signal output end of the power-stage circuit unit; and

an output current of the first current source module is equal to the fixed current, and the current is independent of a temperature; an output current of the second current source module is directly proportional to the first sampled voltage; an output current of the third current source module is directly proportional to the power supply voltage; and an output current of the fourth current source module is directly proportional to the controllable reference voltage.

7. The DC-DC converter according to claim 4, wherein

the error amplifier module comprises an operational amplifier module, a first resistor, a second capacitor, and a third capacitor, wherein

a first output end of the reference voltage and reference current module is connected to an in-phase input end of the operational amplifier module, a second sampled voltage output end of the output voltage sampling network module is connected to an out-phase input end of the operational amplifier module, at the same time, the out-phase input end of the operational amplifier module is connected to the first resistor and the second capacitor, another end of the first resistor is connected to the third capacitor, another end of the third capacitor is connected to an other end of the second capacitor in parallel, and is then connected to an output end of the operational amplifier module, and at the same time, the output end of the operational amplifier module is connected to an out-phase input end of the comparator module in the loop core module.

8. The DC-DC converter according to claim 4 or 6, wherein

in the Vramp generation module, when the fourth control signal controls the switch transistor to be turned on, the slope compensation voltage output by the switch transistor is clamped to an output potential of the bias voltage source and remains unchanged;

when the fourth control signal controls the switch transistor to be turned off, the slope compensation voltage output by the switch transistor starts to increase over time based on the output potential of the bias voltage source, and an increasing slope of the slope compensation voltage is related to the power supply voltage, the first sampled voltage, and the controllable reference voltage; and

in the loop core module, the Vramp generation module and the comparator module form a fast path, and the error amplifier module and the comparator module form a slow path.

9. The DC-DC converter according to claim 3, wherein

the logic control unit comprises a comprehensive circuit unit and a logic core circuit unit, wherein

the comprehensive circuit unit comprises a startup circuit, a PWM/PFM switching circuit, a positive over-current protection circuit, a negative over-current protection circuit, and an inductor current zero-crossing detection circuit; and the comprehensive circuit unit is used for startup and running mode control of the DC-DC converter, and related circuit protection; and

the logic core circuit unit is configured to form the first control signal and the second control signal through logic control based on an input controllable reference voltage, a frequency signal, a third control signal, and the second sampled voltage, and provide the first control signal and the second control signal to the power-stage circuit unit.

10. The DC-DC converter according to claim 9, wherein

the logic core circuit unit comprises a minimum turn-on time module, a first RS trigger module, a second RS trigger module, a forced PWM module, a first logic OR gate, a logic AND gate, a first inverter, and a second inverter, wherein

an output end of the comparator module in the loop core module is connected to an input end of the minimum turn-on time module, and an output end of the minimum turn-on time module is connected to a second input end of the first logic OR gate; an inductor current limiting signal output end of the positive over-current protection circuit is connected to a first input end of the first logic OR gate; and an output end of the first logic OR gate is connected to an input end of the first RS trigger module; and

an enable end of the first RS trigger module and an enable end of the second RS trigger module are separately connected to an enable signal input end, and the input end of the first RS trigger module and an input end of the second RS trigger module are separately connected to an output end of a Clk generation module; an output end of the first RS trigger module is connected to an input end of the first inverter and an input end of the second inverter, and an output end of the first inverter is connected to the first control signal output end; an output end of the second inverter is connected to a first input end of the logic AND gate; and an output end of the forced PWM module is connected to the input end of the second RS trigger module, an output end of the second RS trigger module is connected to a second input end of the logic AND gate, and an output end of the logic AND gate is connected to the second control signal output end.

11. The DC-DC converter according to claim 10, wherein

the forced PWM module comprises a hysteresis comparator module, a counter module, a third inverter, and a second logic OR gate, wherein

an in-phase input end of the hysteresis comparator module is connected to a second sampled voltage output end of an output voltage sampling network module, an out-phase input end of the hysteresis comparator module is connected to a first output end of a reference voltage and reference current module, an output end of the hysteresis comparator module is connected to an input end of the counter module, and an output end of the counter module is connected to a first input end of the second logic OR gate; an output end of the inductor current zero-crossing detection circuit is connected to an input end of the third inverter, and an output end of the third inverter is connected to a second input end of the second logic OR gate; and an output end of the second logic OR gate is connected to the input end of the second RS trigger module.

12. The DC-DC converter according to claim 10 or 11, wherein

when an output voltage of the DC-DC converter jumps from a high voltage to a low voltage, the controllable reference voltage rapidly decreases, the second sampled voltage is greater than the controllable reference voltage, the DC-DC converter switches to an FPWM working mode, and the NMOS power switch transistor discharges a ceramic capacitor with maximum turn-on time, to implement a rapid response to the output voltage of the DC-DC converter.

13. An integrated circuit chip, comprising the DC-DC converter according to any one of claims 1 to 12.

14. An electronic device, comprising the DC-DC converter according to any one of claims 1 to 12.

FIG. 1(a)

FIG. 1(b)

FIG. 2

FIG. 3

FIG. 4

FIG. 5

EP 4 701 060 A1

FIG. 6(a)

FIG. 6(b)

FIG. 7

## INTERNATIONAL SEARCH REPORT

| International application No. |
| --- |
| **PCT/CN2024/088994** |

**A. CLASSIFICATION OF SUBJECT MATTER**

H02M 3/158(2006.01)i;  H02M 1/088(2006.01)n;  H02M 1/38(2007.01)n;  H03K 17/687(2006.01)n

According to International Patent Classification (IPC) or to both national classification and IPC

**B. FIELDS SEARCHED**

Minimum documentation searched (classification system followed by classification symbols)

IPC:  H02M,H03K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 跟踪, 追踪, 跟随, 斜坡, 斜率, 补偿, 输出电压, 输入, 发射功率, 第一, 第二, 采样, 反馈, 控制, 射频前端, 基带, ATP, track+, slope compensat+, output, input, transmit+ power, first, second, sampl+, feedback, control+, radio frequency, rf, baseband

**C. DOCUMENTS CONSIDERED TO BE RELEVANT**

| Category* | Citation of document, with indication, where appropriate, of the relevant passages | Relevant to claim No. |
| --- | --- | --- |
| PX | CN 116455219 A (VANCHIP (TIANJIN) ELECTRONIC TECHNOLOGY CO., LTD.) 18 July 2023 (2023-07-18)<br>claims 1-14 | 1-14 |
| X | CN 102761249 A (ENERGY PASS INC.) 31 October 2012 (2012-10-31)<br>description, paragraphs 2 and 44-52, and figure 5 | 1, 2, 13, 14 |
| A | CN 105610322 A (SHENZHEN POWLICON MICROELECTRONIC CO., LTD.) 25 May 2016 (2016-05-25)<br>entire document | 1-14 |
| A | CN 106374745 A (XIDIAN UNIVERSITY) 01 February 2017 (2017-02-01)<br>entire document | 1-14 |
| A | CN 110752747 A (SAMSUNG ELECTRONICS CO., LTD.) 04 February 2020 (2020-02-04)<br>entire document | 1-14 |
| A | WO 2012010613 A1 (ANACORES LTD. et al.) 26 January 2012 (2012-01-26)<br>entire document | 1-14 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **01 August 2024** | **06 August 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/088994**

| Patent document cited in search report | | | Publication date (day/month/year) | Patent family member(s) | | | Publication date (day/month/year) |
|---|---|---|---|---|---|---|---|
| CN | 116455219 | A | 18 July 2023 | None | | | |
| CN | 102761249 | A | 31 October 2012 | TW | 201244356 | A | 01 November 2012 |
| | | | | TWI | 463778 | B | 01 December 2014 |
| | | | | US | 2012274295 | A1 | 01 November 2012 |
| | | | | US | 8912769 | B2 | 16 December 2014 |
| | | | | CN | 102761249 | B | 19 August 2015 |
| CN | 105610322 | A | 25 May 2016 | None | | | |
| CN | 106374745 | A | 01 February 2017 | CN | 106374745 | B | 17 May 2019 |
| CN | 110752747 | A | 04 February 2020 | TW | 202023167 | A | 16 June 2020 |
| | | | | KR | 20200010830 | A | 31 January 2020 |
| | | | | KR | 20240017377 | A | 07 February 2024 |
| | | | | US | 2020028435 | A1 | 23 January 2020 |
| | | | | US | 10879804 | B2 | 29 December 2020 |
| | | | | JP | 2020017266 | A | 30 January 2020 |
| | | | | JP | 7414412 | B2 | 16 January 2024 |
| | | | | EP | 3599710 | A1 | 29 January 2020 |
| | | | | EP | 3599710 | B1 | 05 April 2023 |
| | | | | TW | 832856 | B1 | 21 February 2024 |
| WO | 2012010613 | A1 | 26 January 2012 | IES | 20100461 | A2 | 20 July 2011 |
| | | | | IE | 85816 | B3 | 20 July 2011 |

Form PCT/ISA/210 (patent family annex) (July 2022)

**EP 4 701 060 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103345289 B